# EUROPEAN PATENT APPLICATION

(11) **EP 4 481 962 A1**
(43) Date of publication of application: **25.12.2024**
(21) Application number: 23752980.5
(22) Date of filing: 14.02.2023
(51) Int. Cl.: H01S 5/0239, H01S 5/026, H01S 5/0683, H01S 5/50

(54) **OPTICAL TRANSMITTER**

(30) Priority: 14.02.2022 JP 2022020836
(71) Applicant: Nippon Telegraph And Telephone Corporation, Chiyoda-ku Tokyo 100-8116 (JP); NTT Innovative Devices Corporation, Yokohama-shi, Kanagawa 221-0031 (JP)
(72) Inventor: KANAZAWA, Shigeru, Musashino-shi, Tokyo 180-8585 (JP); SHINDO, Takahiko, Musashino-shi, Tokyo 180-8585 (JP); CHEN, Mingchen, Musashino-shi, Tokyo 180-8585 (JP); KOSUGA, Shohei, Musashino-shi, Tokyo 180-8585 (JP); WATANABE, Naoya, Yokohama-shi, Kanagawa 221-0031 (JP); KUBO, Hiroyoshi, Yokohama-shi, Kanagawa 221-0031 (JP)
(74) Representative: TBK
(86) International application number: PCT/JP2023/004889
(87) International publication number: WO 2023/153518

(57) **Abstract**

Provided is an EA-DFB laser assembly equipped with an SOA that can achieve size reduction and prevention of bandwidth degradation caused by crosstalk between wires. An optical transmitter according to the present disclosure is an optical transmitter using the EA-DFB laser assembly and includes: an RF line configured to supply an electric signal; an EA-DFB laser chip configured to convert the electric signal to an optical signal and including an LD configured to oscillate laser light to be a source of signal light to be emitted, an EA modulator configured to perform intensity modulation on the laser light, an SOA configured to amplify the signal light subjected to the intensity modulation, and a waveguide configured to guide the laser light and the signal light; a first parallel-plate capacitor for removing noise in an electric current to be supplied to the LD, a second parallel-plate capacitor for removing noise in an electric current to be supplied to the SOA, and multiple wires electrically connecting the elements, the second parallel-plate capacitor is arranged at a position adjacent to the SOA and the RF line.

## Description

### Technical Field

The present disclosure relates to an optical transmitter, more specifically, relates to an EA-DFB laser assembly equipped with an SOA.

### Background Art

An optical transmitter is a device that converts an electric signal to an optical signal and transmits the optical signal in an optical communication system, and has a role of a light source of the optical signal. For such an optical transmitter, demands such as mid- and long-distance transmission at high speed, an increase of output, reduction of power consumption, and size reduction are growing day by day with spreading of highspeed Internet services and the like in recent years.

Examples of an optical transmitter that satisfies the above-mentioned demands include an EA-DFB laser assembly equipped with a distributed feedback laser integrated with electro-absorption (hereinafter, referred to as EA-DFB laser). The EA-DFB laser is an element that guides laser light, oscillated from a DFB laser to which an electric current is applied, to an EA modulator and applies an RF signal to the EA modulator to emit signal light subjected to intensity modulation. Since the EA-DFB laser has characteristics of high modulation speed and small refractive index change in modulation, the EA-DFB laser assembly equipped with the EA-DFB laser is gaining attention as an optical transmitter suitable for mid- and long-distance transmission at high speed.

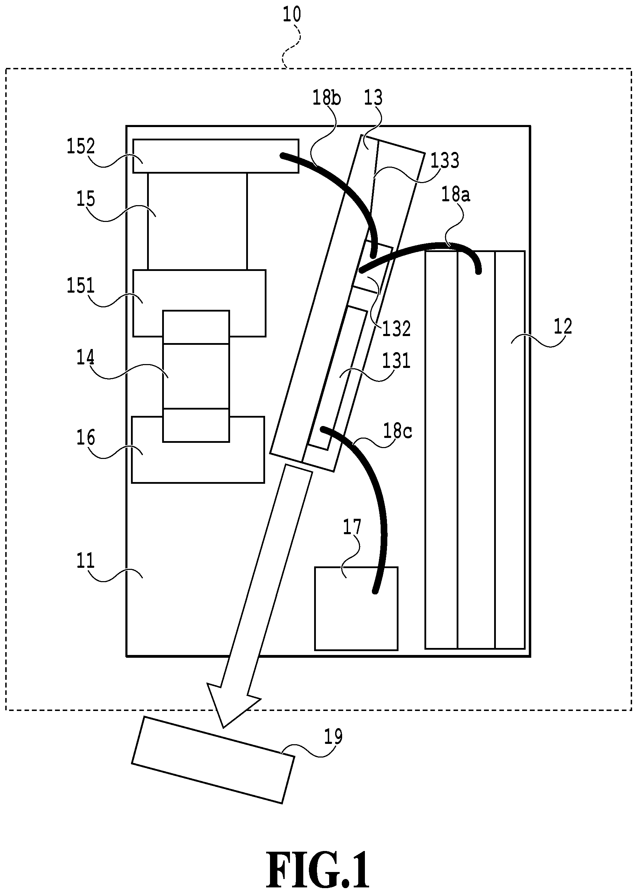

FIG.1 is a diagram illustrating a structure of an EA-DFB laser assembly 10 according to a conventional technique. As illustrated in FIG.1, the EA-DFB laser assembly 10 according to the conventional technique includes the following elements that are installed on a subcarrier 11. The elements include a radio frequency (hereinafter, referred to as RF) line 12 configured to supply an electric signal, an EA-DFB laser chip 13 configured to convert the electric signal to an optical signal, a LD electrode 131 configured to supply an electric current to a DFB laser (not illustrated) included inside the EA-DFB laser chip 13, an EA modulator electrode 132 configured to supply an electric current to be applied to an EA modulator (not illustrated) included inside the EA-DFB laser chip 13, a surface mounted capacitor 14 configured to terminate an RF signal, a termination resistor 15 for suppressing reflection of the electric current applied to the EA modulator, a termination resistor electrode 151 configured to electrically connect the surface mounted capacitor 14 and the termination resistor 15 to each other, a termination resistor electrode 152 for electrically connecting the termination resistor 15 and the EA modulator to each other, a ground pad 16 for connecting the surface mounted capacitor 14 and a ground potential to each other, a parallel-plate capacitor 17 for removing noise in the electric current to be supplied to the DFB laser (not illustrated) included inside the EA-DFB laser chip 13, and wires 18a to 18c configured to electrically connect the elements to one another.

Moreover, the EA-DFB laser chip 13 includes a waveguide 133 configured to guide light inside the EA-DFB laser chip 13.

In this case, the RF line 12 and the EA modulator electrode 132 are electrically connected to each other by the wire 18a, the EA modulator electrode 132 and the termination resistor electrode 152 are electrically connected to each other by the wire 18b, and the LD electrode 131 and the parallel-plate capacitor 17 are electrically connected to each other by the wire 18c.

In the EA-DFB laser assembly 10 configured as described above, signal light subjected to intensity modulation by the EA-DFB laser chip 13 is emitted based on the RF signal supplied from the RF line 12. In this case, as illustrated by the arrow in FIG. 1, light not subjected to intensity modulation is also emitted from a terminal (end portion on the opposite side to an emitting end of the signal light) of the EA-DFB laser chip 13. This light emitted from the terminal may be measured as appropriate to inspect an output of laser light oscillated from the LD, or to estimate an output of the emitted light signal based on the light emitted from the terminal. The measurement is performed by using, for example, a power monitor 19.

The EA-DFB laser assembly 10 according to the conventional technique as described above is capable of modulation at high speed, but large loss of the light signal in intensity modulation is considered problematic. As means for solving this problem, there is proposed a technique of improving power efficiency by further equipping the EA-DFB laser with a semiconductor optical amplifier (hereinafter, referred to as SOA).

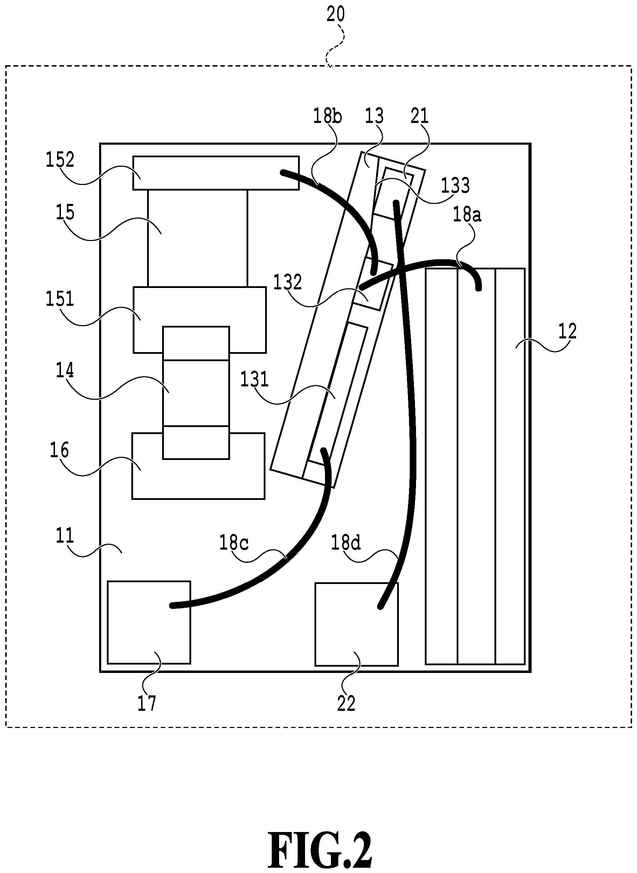

FIG.2 is a diagram illustrating a structure of an EA-DFB laser assembly 20 equipped with an SOA according to a conventional technique. As illustrated in FIG.2, the EA-DFB laser assembly 20 equipped with the SOA further includes an SOA electrode 21 to be an electrode of an SOA (not illustrated) installed in the EA-DFB laser chip 13 in the EA-DFB laser assembly 10 illustrated in FIG. 1 and a parallel-plate capacitor 22 installed on the subcarrier 11 and electrically connected to the SOA electrode 21 by a wire 18d. The parallel-plate capacitor 22 has a role of removing noise in an electric current applied to the SOA.

In the EA-DFB laser assembly 20 configured as described above, the configuration is such that the signal light subjected to intensity modulation is amplified by the SOA and then emitted. Accordingly, the EA-DFB laser assembly 20 can emit signal light of a higher output than the EA-DFB laser assembly 10.

As described above, in the EA-DFB laser assembly equipped with the SOA according to the conventional technique like the EA-DFB laser assembly 20, the parallel-plate capacitor 22 for noise removal needs to be installed for the SOA. However, in the structure in the conventional technique, installation of the parallel-plate capacitor 22 causes the parallel-plate capacitor 17 connected to the LD electrode 131 to be installed at a position where the parallel-plate capacitor 17 interferes with an optical path of the light emitted from the terminal of the EA-DFB laser chip 13. Accordingly, in the output measurement of the light emitted from the terminal of the EA-DFB laser chip 13 described above, the light interferes with the parallel-plate capacitor 17, and power loss occurs. In order to suppress this, measures such as the following measure are taken. The subcarrier 11 is designed to have a large size to secure a sufficient space so that the parallel-plate capacitor 17 and the light emitted from the terminal of the EA-DFB laser chip 13 do not interfere with each other. However, this measure has such a problem that the size of the entire optical transmitter increases.

Moreover, in the configuration of the EA-DFB laser assembly 20 according to the conventional technique, as illustrated in FIG.2, arrangement is such that the wire 18a and the wire 18d intersect each other. Accordingly, there is such a problem that, in the case where an interval between the two wires is small, crosstalk occurs and bandwidth degradation of the EA modulator occurs.

### Citation List

### Non Patent Literature

NPL 1: Ning Hua Zhu et al., "Electrical and Optical Coupling in an Electroabsorption Modulator Integrated With a DFB Laser", Journal of Quantum Electronics, vol. 43, no. 7, pp. 535-544, 2007.

### Summary of Invention

The present disclosure has been made in view of the problems described above, and an object is to provide an EA-DFB laser assembly that is equipped with an SOA and that can achieve size reduction and prevent bandwidth degradation due to crosstalk between wires.

For the above-mentioned problems, the present disclosure provides an optical transmitter using an assembly of a distributed feedback laser integrated with electro-absorption (EA-DFB laser), the optical transmitter including: an RF line configured to supply an electric signal; an EA-DFB laser chip configured to convert the electric signal to an optical signal and including a laser diode (LD) configured to oscillate laser light to be a source of signal light to be emitted, an electro-absorption (EA) modulator configured to perform intensity modulation on the laser light, a semiconductor optical amplifier (SOA) configured to amplify the signal light subjected to the intensity modulation, and a waveguide configured to guide the laser light and the signal light; a first parallel-plate capacitor for removing noise in an electric current to be supplied to the LD, a second parallel-plate capacitor for removing noise in an electric current to be supplied to the SOA, and multiple wires electrically connecting the elements. The second parallel-plate capacitor is arranged at a position adjacent to the SOA and the RF line.

The optical transmitter using the EA-DFB laser assembly according to the present disclosure has such an effect that the optical transmitter can achieve size reduction, suppression of bandwidth degradation by prevention of crosstalk, and an increase in accuracy of LD output inspection.

### Brief Description of Drawings

[FIG. 1] FIG. 1 is a diagram illustrating a structure of an EA-DFB laser assembly according to a conventional technique.
[FIG.2] FIG.2 is a diagram illustrating a structure of an EA-DFB laser assembly equipped with an SOA according to a conventional technique.
[FIG.3] FIG.3 is a diagram illustrating a structure of an EA-DFB laser assembly equipped with an SOA according to a first embodiment of the present disclosure.
[FIG.4] FIG.4 is a diagram illustrating a structure of an EA-DFB laser assembly equipped with an SOA according to a second embodiment of the present disclosure.

### Description of Embodiments

Various embodiments of the present disclosure are explained below in detail with reference to the drawings. The same or similar reference numerals denote the same or similar elements, and overlapping explanation is omitted in some cases. The following explanation is an example, and can be carried out with some of configurations omitted or modified or with additional configurations, as long as such omission, modification, and addition do not depart from the spirit of the embodiments of the present disclosure.

An EA-DFB laser assembly according to the present disclosure is an optical transmitter of an EA-DFB laser assembly equipped with an SOA as illustrated in FIG.2. However, the EA-DFB laser assembly is different from that in the conventional technique in that the parallel-plate capacitor connected to the SOA electrode is arranged immediately adjacent to the SOA so as not to interfere with the light emitted from the terminal unlike in the conventional technique.

### (First Embodiment)

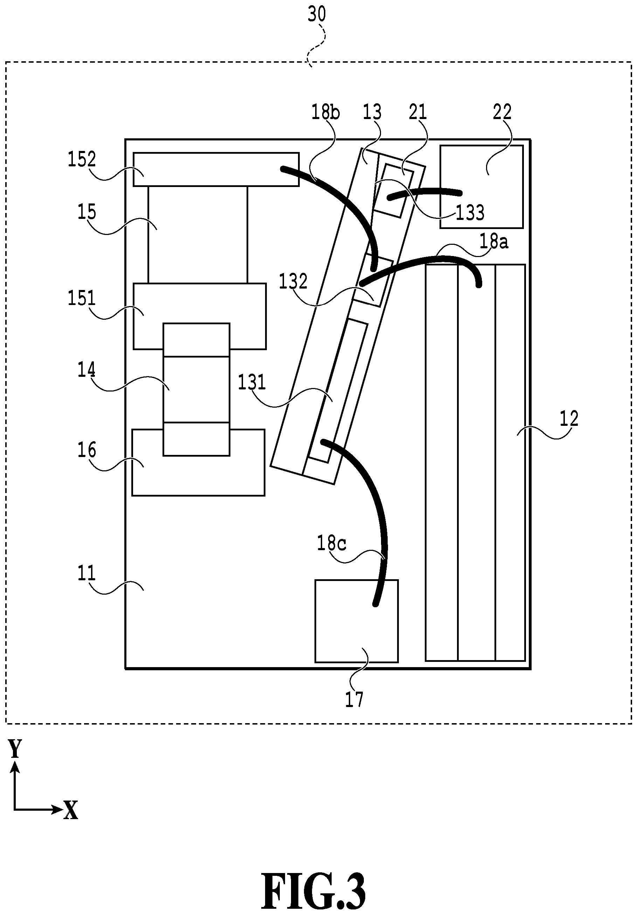

FIG.3 is a diagram illustrating a structure of an EA-DFB laser assembly 30 equipped with an SOA according to a first embodiment of the present disclosure. The EA-DFB laser assembly 30 basically has a similar configuration to the EA-DFB laser assembly 20 illustrated in FIG.2, but the parallel-plate capacitor 22 for the SOA is arranged at a position that is near the SOA electrode 21 and that is adjacent to the RF line 12.

The EA-DFB laser assembly 30 having such a configuration can be equipped with the parallel-plate capacitors 17 and 22 without the design in which the subcarrier 11 has a large size as in the conventional technique, and the light emitted from the terminal of the EA-DFB laser chip 13 can be measured without loss. In addition, since the wire 18d connecting the SOA electrode 21 and the parallel-plate capacitor 22 does not intersect the wire 18a connecting the EA modulator electrode 132 and the RF line 12, bandwidth degradation due to crosstalk can be also prevented.

Evaluation was performed to verify that loss of light emitted from the terminal of the EA-DFB laser chip 13 does not occur in the EA-DFB laser assembly 30 according to the first embodiment of the present disclosure. In the present evaluation, comparison evaluation was performed for the EA-DFB laser assembly 30 and an EA-DFB laser assembly in which the elements were arranged in a manner similar to the conventional technique as illustrated in FIG.2 on the subcarrier 11 having the same shape as that in the EA-DFB laser assembly 30 (corresponding to the EA-DFB laser assembly 20 in which the subcarrier 11 was not designed to have a large size). Note that, in this evaluation, as an example, the length of the EA modulator was 125 µm, the width of the RF line 12 was 0.3 mm, the parallel-plate capacitors 17 and 22 were each 0.25×0.25 mm.

The size of the subcarrier 11 of the EA-DFB laser assembly 30 configured as described above was such that the width (length in the X direction in FIG.3) was 1.17 mm and the length (length in the Y direction in FIG.3) was 1.6 mm. Meanwhile, the size of the subcarrier 11 of the EA-DFB laser assembly 20 was such that the width was 1.4 mm and the length was 1.6 mm. Specifically, it can be found that the width of the EA-DFB laser assembly 30 according to the present disclosure is reduced by about 16% from the width of the EA-DFB laser assembly 20 that is the conventional technique.

Moreover, output measurement of the light emitted from the terminal was performed for each of the EA-DFB laser assembly 30 and the EA-DFB laser assembly in which the elements were arranged in a manner similar to the conventional technique as illustrated in FIG.2 on the subcarrier 11 having the same shape as that in the EA-DFB laser assembly 30. Note that the output measurement was executed by using the power monitor 19 as illustrated in FIG. 1. As a result, in the EA-DFB laser assembly in which the elements were arranged in a manner similar to the conventional technique, the output of the light was measured to be 0.1 mW. Meanwhile, in the EA-DFB laser assembly 30, an output of 0.3 mW was measured. This was due to the fact that the light interfered with the parallel-plate capacitor 17 and loss occurred with this interreference in the EA-DFB laser assembly in which the elements were arranged in a manner similar to the conventional technique. In other words, the fact that loss of light based on the interference with the parallel-plate capacitor 17 as described above does not occur in the EA-DFB laser assembly 30 is recognized by the present verification.

In addition, frequency response was measured for each of the EA-DFB laser assembly 30 and the EA-DFB laser assembly in which the elements were arranged in a manner similar to the conventional technique. As a result, a frequency in a 3 dB band was 24 GHz in the EA-DFB laser assembly in which the elements were arranged in a manner similar to the conventional technique, while the frequency was 39 GHz in the EA-DFB laser assembly 30. This is due to the fact that, since the wire 18a and the wire 18d intersected each other in the EA-DFB laser assembly in which the elements were arranged in a manner similar to the conventional technique, ripple caused by crosstalk occurred. In other words, the fact that, since there is no such intersection of the wire 18a and the wire 18d in the EA-DFB laser assembly 30, degradation of the bandwidth due to ripple caused by crosstalk is suppressed is recognized by the present verification.

From the above description, it can be said that the EA-DFB laser assembly 30 of the present disclosure can measure the light emitted from the terminal of the EA-DFB laser chip 13 without loss of the light while having a smaller size than that in the conventional technique. Moreover, it can be said that, since the EA-DFB laser assembly 30 has the structure in which the wires electrically connecting the elements to one another do not intersect each other, the degradation of bandwidth caused by crosstalk can be suppressed.

### (Second Embodiment)

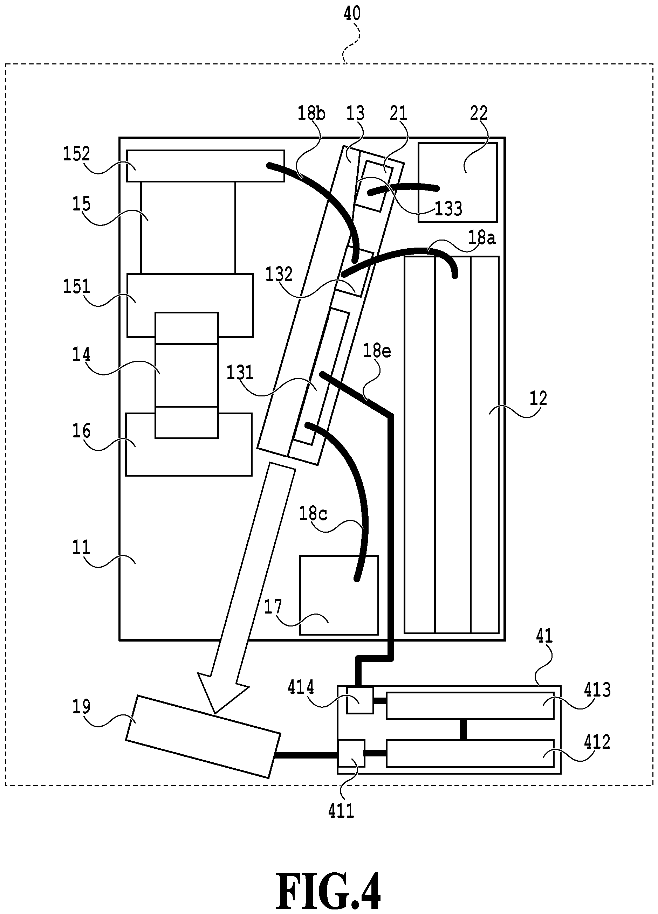

FIG.4 is a diagram illustrating a structure of an EA-DFB laser assembly 40 equipped with an SOA according to a second embodiment of the present disclosure. The EA-DFB laser assembly 40 further includes, in addition to the configuration of the EA-DFB laser assembly 30 illustrated in FIG.3, the power monitor 19 configured to measure the power of the light emitted from the terminal and a feedback control unit 41 configured to generate a signal for feedback control of the power of the outputted signal light based on a measurement result of the power monitor 19. The feedback control unit 41 is electrically connected to the LD electrode 131 by a wire 18e, and is configured to be capable of performing feedback control of the output of the light oscillated from the LD.

Moreover, the feedback control unit 41 includes a reception port 411 configured to receive data of the measurement result transmitted from the power monitor 19, a memory 412 configured to temporarily store the received data, a processing unit 413 configured to estimate the output of the signal light based on the measurement result of the power monitor 19 and generate a control signal for controlling the output of the signal light to a desired output, and a transmission port 414 configured to transmit the generated control signal to the LD electrode 131.

In the EA-DFB laser assembly 40 having such a configuration, output of the emitted optical signal is feedback-controlled based on the output of the light emitted from the terminal of the EA-DFB laser chip 13, and the EA-DFB laser assembly 40 can transmit a signal light with a desired output more stably. Although an EA-DFB laser assembly having the feedback control mechanism as described above is already known, since the light emitted from the terminal of the EA-DFB laser chip 13 and the parallel-plate capacitor 17 do not interfere with each other in the EA-DFB laser assembly according to the present disclosure as described above, accurate output measurement of the light is possible. Accordingly, feedback control more accurate than that in the conventional technique is possible. Moreover, since the interference with the parallel-plate capacitor 17 that may be a cause of an error can be ignored also for estimation of the output of the signal light in the processing unit 413, an algorithm of computation for generating the control signal can be simplified.

Note that the waveguide 133 is illustrated in Figs. 1 to 4 as a bent waveguide that has an angle with respect to a perpendicular line of an end surface of the EA-DFB laser chip 13 near the emitting portion in the above explanation, and this design has an intention of suppressing reflection at the end surface. Although the waveguide having this angle is not necessarily a configuration requirement required to achieve the function as the optical transmitter, the waveguide is preferably designed to have the angle from the viewpoint of reducing the loss of the emitted signal light. Particularly, it is more preferable that the angle is about 5° to 7°.

### Industrial Applicability

As described above, the optical transmitter using the EA-DFB laser assembly according to the present disclosure has such effects that the optical transmitter can achieve size reduction, suppression of bandwidth degradation by prevention of crosstalk, and an increase in accuracy of LD output inspection. Accordingly, the optical transmitter is expected to be applied particularly to an optical communication system for mid and long distances, as an optical transmitter that has a smaller size than that in a conventional technique and that can achieve more stable transmission of an optical signal at high efficiency.

## Claims

1. An optical transmitter using an assembly of a distributed feedback laser integrated with electro-absorption (EA-DFB laser), the optical transmitter comprising:
the EA-DFB laser chip comprising:
a laser diode (LD) configured to oscillate laser light to be a light source of signal light to be emitted,
an electro-absorption (EA) modulator configured to perform intensity modulation on the laser light,
a semiconductor optical amplifier (SOA) configured to amplify the signal light subjected to the intensity modulation, and
a waveguide configured to guide the laser light and the signal light;
an RF line configured to supply an electric signal for performing the intensity modulation, the RF line having an end portion located near the EA modulator;
a first parallel-plate capacitor for removing noise in an electric current to be supplied to the LD, the first parallel-plate capacitor arranged near the LD; and
a second parallel-plate capacitor for removing noise in an electric current to be supplied to the SOA,
wherein the second parallel-plate capacitor is arranged at a position that is near the SOA and that is adjacent to the end portion of the RF line.

2. The optical transmitter according to claim 1, further comprising:
a power monitor configured measure an output of light emitted from a terminal of the EA-DFB laser chip; and
a feedback control unit electrically connected to the power monitor and the LD and configured to control an output of the signal light based on a measurement result of the power monitor.

3. The optical transmitter according to claim 1 or 2, wherein a portion of the waveguide that guides the signal light amplified by the SOA is a bent waveguide having an angle with respect to a perpendicular line of an end surface of the EA-DFB laser chip.
